# EUROPÄISCHE PATENTSCHRIFT

(11) **EP 1 118 128 B1**
(45) Veröffentlichungstag und Bekanntmachung des Hinweises auf die Patenterteilung: **06.04.2005**
(21) Anmeldenummer: 99969850.9
(22) Anmeldetag: 28.09.1999
(51) Int. Cl.: H01L 41/04

(54) **VERFAHREN UND ANORDNUNG ZUR DIAGNOSE EINES KAPAZITIVEN AKTORS**
METHOD AND ARRANGEMENT FOR DIAGNOSING A CAPACITIVE ACTUATOR
PROCEDE ET SYSTEME POUR DIAGNOSTIQUER UN ACTIONNEUR CAPACITIF

(30) Priorität: 30.09.1998 DE 19845042
(43) Veröffentlichungstag der Anmeldung: 25.07.2001
(73) Patentinhaber: SIEMENS AKTIENGESELLSCHAFT, 80333 München (DE)
(72) Erfinder: GERKEN, Hartmut, D-93152 Nittendorf (DE); HOFFMANN, Christian, D-93057 Regensburg (DE); FREUDENBERG, Hellmut, D-93080 Grossberg (DE); PIRKL, Richard, D-93053 Regensburg (DE); HECKER, Martin, D-93336 Laimerstadt (DE); SCHROD, Walter, D-93057 Regensburg (DE)
(86) Internationale Anmeldenummer: PCT/DE1999/003120
(87) Internationale Veröffentlichungsnummer: WO 2000/019549

(56) Entgegenhaltungen:
- DE-A- 19 644 521

## Beschreibung

Die Erfindung betrifft ein Verfahren zur Diagnose eines kapazitiven Aktors und einer dazugehörigen Ansteuerschaltung, insbesondere eines piezoelektrischen Aktors für ein Kraftstoffeinspritzventil, gemäß dem Oberbegriff des Patentanspruchs 1 und eine Anordnung zur Durchführung des Verfahrens gemäß dem Oberbegriff des Patentanspruchs 21.

Ein Verfahren zum Ansteuern eines Aktors ist in DE 196 44 521 A1 beschrieben. Danach wird einem kapazitiven Aktor eine vorgebbare Energie zugeführt, indem ein auf einen Anfangsspannungswert gelader Ladekondensator über eine Umschwingspule solange auf den Aktor umgeladen wird, bis der Ladekondensator einen vorgebbaren Endspannungswert erreicht hat. Die auf den Aktor übertragene Energie wird von der Spannungsdifferenz zwischen Anfangsspannungswert und Endspannungswert bestimmt. Alternativ werden der dem Aktor zugeführte Aktorstrom und die am Aktor anliegende Aktorspannung multipliziert, das Produkt integriert und der Integralwert mit einem vorgebbaren Sollwert verglichen. Der Umladevorgang wird abgebrochen, wenn der Integralwert den Sollwert erreicht oder übersteigt.

Es ist Aufgabe der Erfindung, ein Verfahren zur Diagnose eines kapazitiven Aktors und einer dazugehörigen Ansteuerschaltung bereitzustellen.

Die Aufgabe der Erfindung wird durch die im Patentanspruch 1 und Patentanspruch 19 genannten Merkmale gelöst.

Die Erfindung geht von der Überlegung aus, daß eine Ansteuerschaltung mit einem Ladekondensator und einer Umschwingspule, die zusammen mit dem Aktor einen Serienschwingkreis bilden, bei Auftreten von aktortypischen Fehlern in einer voraussehbaren Weise reagiert. So wird aus einer am Aktor gemessenen Aktorspannung, eines durch den Aktor fließenden Aktorstroms oder einer auf den Aktor aufgebrachten Aktorladung durch Vergleichen mit vorgegebenen Referenzwerten auf den Funktionszustand des Aktors und der dazugehörigen Ansteuerschaltung geschlossen.

Weitere vorteilhafte Ausbildungen und Verbesserungen der Erfindung sind in den abhängigen Patentansprüchen angegeben.

Im folgenden wird die Erfindung anhand der Figuren näher erläutert; es zeigen:
- Figur 1: Der Verlauf des Aktorstroms und der Aktorspannung in Abhängigkeit von Funktionszuständen,
- Figur 2: Der Verlauf des Aktorstroms und der Aktorspannung in Abhängigkeit von weiteren Funktionszuständen,
- Figur 3: Der Verlauf des Aktorstroms und der Aktorspannung in Abhängigkeit von weiteren Funktionszuständen,
- Figur 4: Der Verlauf des Aktorstroms mit der aufintegrierten Aktorladung in Abhängigkeit von von weiteren Funktionszuständen,
- Figur 5: Der Verlauf des Aktorstroms und der Aktorspannung in zwei aufeinanderfolgenden Ansteuervorgängen,
- Figur 6: eine Ansteuerschaltung mit einer Umladeschaltung, einem Steuergerät und Aktoren zur Durchführung des Verfahrens.

Ein Aktor Pm besteht aus mehreren übereinander angeordneten Piezoscheiben, die einen Piezostapel bilden. Die Piezoscheiben sind über vorzugsweise seitlich am Piezostapel angebrachten Kontaktflächen elektrisch miteinander verbunden. Der Aktor Pm längt sich bei Angelegen einer Aktorspannung up.

Aktoren werden beispielsweise in Kraftstoffeinspritzventilen eingesetzt, um über ein Ventil den Einspritzvorgang in den Brennraum einer Brennkraftmaschine zu steuern. Für eine schadstoffarme Verbrennung und einen hohen Wirkungsgrad der Brennkraftmaschine ist eine Einspritzmenge mit geringer Abweichung von einer vorgebbaren Solleinspritzmenge wichtig, was nur mit fehlerfreien Aktoren durchgeführt werden kann.

Zur Diagnose von Fehlern im Aktor Pm oder in dessen Zuleitungen wird aus den gemessenen Werten der Aktorspannung up und des Aktorstroms ip auf den Funktionszustand des Aktors Pm und der dazugehörigen Ansteuerschaltung geschlossen. Folgende Funktionszustände können auftreten:
- Der Aktor Pm und dessen Zuleitungen des Aktors Pm weist keine Fehler auf (fehlerfreier Funktionszustand OK).
- Die Kontaktbahnen des Aktors P oder dessen Zuleitungen zur Ansteuerschaltung sind unterbrochen (Unterbrechung F10), so daß der Aktor Pm nicht ausgelenkt wird.
- Der Aktor Pm weist eine zu kleine Aktorkapazität auf (F11).
- Eine oder mehrere Kontaktbahnen im Aktor Pm werden während des Auslenkvorganges kurzzeitig unterbrochen (kurzzeitige Unterbrechung F2), wobei der Auslenkvorgang während einer Anstiegszeit t1 stattfindet. Dadurch wird die Energieübertragung auf den Aktor Pm kurzzeitig unterbrochen, wodurch sich die Auslenkung des Aktors Pm und somit der Einspritzbeginn verzögert, was zu einer Änderung der Einspritzmenge führt.
- Die elektrischen Verbindungen innerhalb des Aktors Pm oder zwischen der Ansteuerschaltung und dem Aktor Pm sind kurzgeschlossen (Kurzschluß F30). Ein Kurzschluß F30 kann im Aktor Pm, in dessen Zuleitungen oder in der Endstufe der Ansteuerschaltung auftreten. Der Aktor Pm wird nicht ausgelenkt.

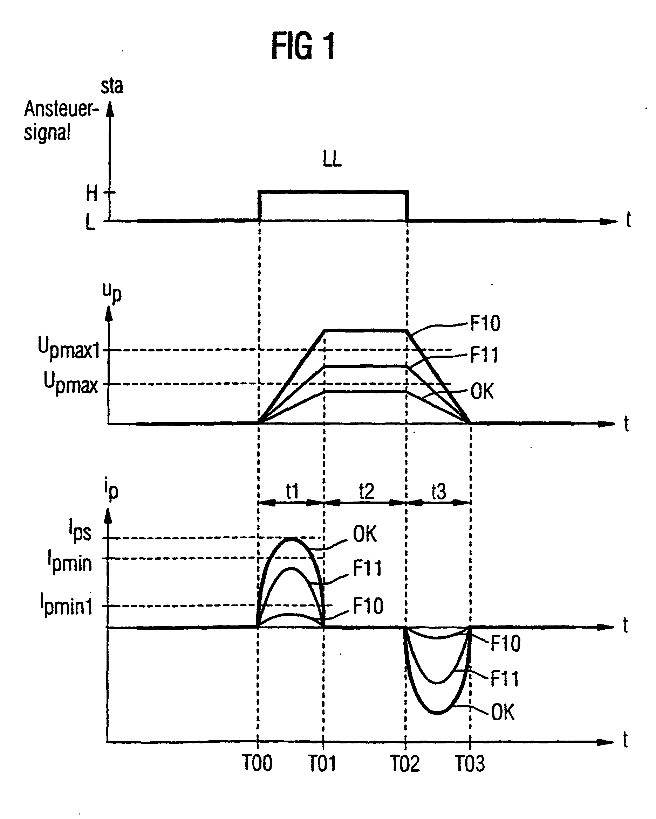

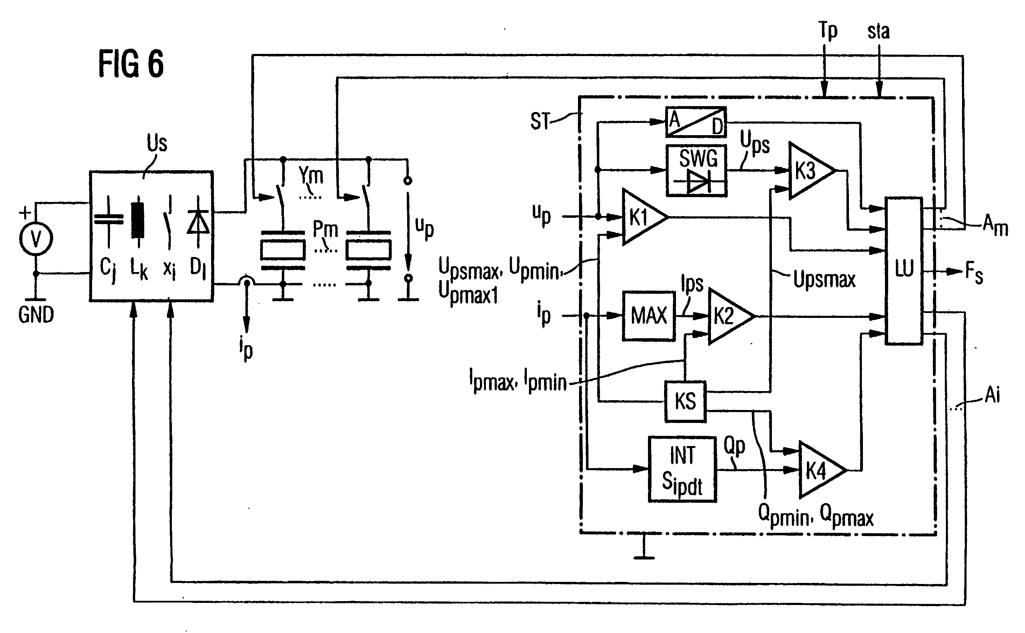

Figur 1 zeigt den zeitlichen Verlauf eines Ansteuersignals sta und verschiedene Spannungs- und Stromverläufe der an einem Aktor Pm gemessenen Aktorspannung up und des durch den Aktor Pm fließenden Aktorstroms ip in Abhängigkeit von verschiedenen Funktionszuständen. Zum Zeitpunkt T00 initiiert ein Ansteuersingnal sta den Beginn eines Ansteuervorgangs eines Aktors Pm. Während der Anstiegszeit t1 wird der Aktor Pm. über eine in Figur 6 beschriebene Ansteuerschaltung bis zum Zeitpunkt T01 aufgeladen, wodurch der Aktor ausgelenkt wird. Die Aktorspannung up steigt annähernd cosinusförmig und der Aktorstrom ip verläuft in einer annähernd sinusförmigen positiven Halbwelle. Nach Beenden des Aufladeevorgangs zum Zeitpunkt T01 wird während einer Haltezeit t2 die Aktorspannung up am Aktor Pm gehalten, wodurch der Aktor Pm in seiner ausgelenkten Position bleibt. Es fließt kein Aktorstrom ip. Am Ende der Haltezeit t2 zum Zeitpunkt T02 initiiert das Ansteuersignal sta das Ende des Ansteuervorgangs. Während der darauffolgenden Abfallzeit t3 wird der Aktor Pm entladen, wobei die Aktorspannung up annähernd cosinusförmig abfällt und der Aktorstrom ip in einer negativen Halbsinusform verläuft. Nach Ende der Abfallzeit t3 zum Zeitpunkt T03 ist der Aktor Pm entladen und in seine Ruheposition zurückgekehrt. Zum Zeitpunkt t02 signalisiert das Ansteuersignal sta das Ende des Ansteuervorganges.

Zur einfacherern Darstellung wurden in den Figuren 1 bis 4 die cosinusförmig ansteigenden und abfallenden Aktorspannungsverläufe annähernd linear steigend und fallend dargestellt.

Während der Anstiegszeit t1 erreicht der Aktorstrom ip im Aktorscheitelstrom Ips seinen Maximalwert.

Die Aktorspannungs- und Aktorstromverläufe in den Figuren 1 bis 5 sind typisch für Umladevorgänge in Abhängigkeit von verschiedenen Funktionszuständen; wobei dem in einer Umladeschaltung Us aus Figur 6 gezeigten Aktor Pm eine Energie oder eine Ladung Qp übertragen wird. Der Aktor Pm wird über eine Umschwingspule Lk von einem Ladekondensator Cj aufgeladen. Der Ladekondensator Cj, die Umschwingspule Lk und der Aktor Pm bilden einen Serienschwingkreis Cj-Lk-Pm, wodurch beim Umladen die in den Figuren 1 bis 5 dargestellten Aktorspannungs- und Stromverläufe in Abhängigkeit von verschiedenen Funktionszuständen entstehen.

In Figur 1 sind Aktorspannungs- und Aktorstromverläufe dargestellt, die den Funktionszuständen OK, F10 und F11 entsprechen, wobei auf einen fehlerfreien Funktionszustand OK angeschlossen wird, wenn die Aktorspannung up unter einem vorgegebenen oberen Spannungswert Upmax oder der Aktorstrom ip über einen vorgegebenen unteren Stromwert Ipmin liegt. Die Aktorspannung up wird während der Anstiegszeit t1 oder vorzugsweise während der Haltezeit t2 gemessen. Der Aktorscheitelstrom Ips wird während der Anstiegszeit t1 durch einen Maximalwertbildner MAX gebildet, der während der Anstiegszeit t1 den Aktorstrom ip auswertet.

Überschreitet die Aktorspannung up den vorgegebenen oberen Spannungswert Upmax oder unterschreitet der Aktorscheitelstrom Ips den unteren Stromwert Ipmin, so wird auf eine Unterbrechung F10 geschlossen. Überschreitet die Aktorspannung einen weiteren oberen Spannungswert Upmax1 oder unterschreitet der Aktorscheitelstrom Ips einen weiteren unteren Stromwert Ipmin1, so wird auf eine zu kleine Aktorkapazität F11 geschlossen. Durch eine zu niedrige Aktorkapazität oder eine Unterbrechung entsteht am Aktor Pm durch den Serienschwingkreis Cjnk und Pm eine Spannungsüberhöhung, die mit einem reduzierten Aktorscheitelstrom Ips einhergeht, und die durch Vergleich mit den vorgegebenen Strom- und Spannungswerten Ipmin, Ipmin1, Upmax, Upmax1 ausgewertet werden.

Zum Ermitteln einer Unterbrechung F10 wird vorzugsweise der Aktorstrom ip ausgewertet, da die Differenz des Aktorstroms ip bei einem fehlerfreien Funktionsszustand OK vom Aktorstrom ip bei einer Unterbrechnung F10 groß genug ist, um durch Wahl geeigneter Schwellwerte eine sichere Unterscheidung der Funktionszustände auch bei geringer Meßgenauigkeit zu ermöglichen.

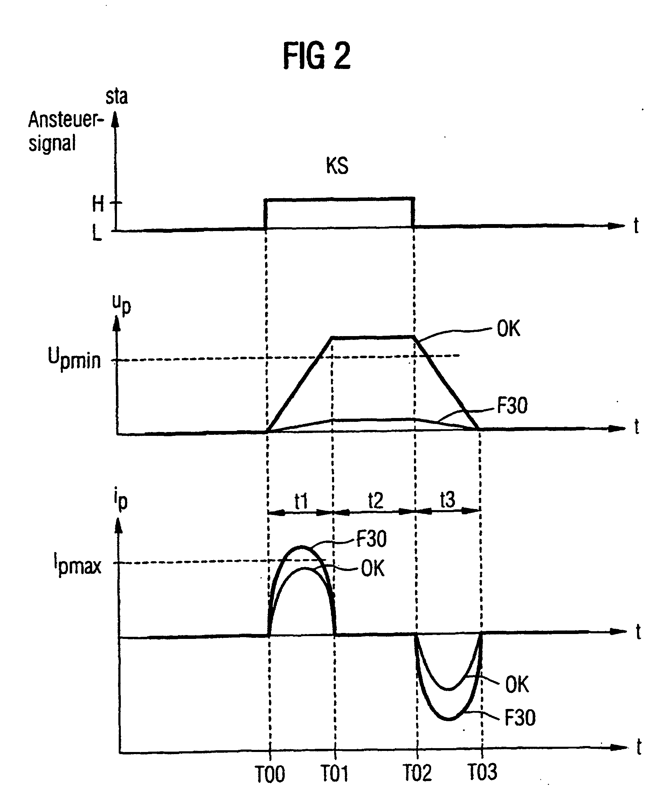

In Figur 2 sind Aktorspannungs- und Aktorstromverläufe dargestellt, die den fehlerfreien Funktionszuständen OK und dem Kurzschluß F30 im Aktor Pm entsprechen. Der Umladevorgang des Reihenschwingkreises Cj-Lk-Pm aus Figur 6 bewirkt beim Kurzschluß F30 eine verringerte, unter einem vorgegebenen unteren Spannungswert Upmin liegenden Aktorspannung up und einen über einem vorgegebenen oberen Stromwert Ipmax liegenden Aktorscheitelstrom Ips.

Aus dem Vergleich der Aktorspannung up oder des Aktorscheitelstroms Ips mit vorgegebenen unteren und oberen Spannungsoder Stromschwellwerten Upmin, Upmax, Upmax1, Ipmin, Ipmin1 und Ipmax wird somit auf die entsprechende Fehlerart geschlossen. Zur Ermittlung des Funktionszustandes reicht schon die Auswertung einer der Größen Aktorstrom ip, Aktorspannung up aus, es können aber auch beide Größen zur Auswertung herangezogen werden.

Zum Ermitteln eines Kurzschlusses F30 wird vorzugsweise die Aktorspannung up ausgewertet, da die Differenz der Aktorspannung up bei einem fehlerfreien Funktionsszustand OK von der Aktorspannung up bei einem Kurzschluß F30 groß genug ist, um durch Wahl geeigneter Schwellwerte eine sichere Unterscheidung der Funktionszustände auch bei geringer Meßgenauigkeit zu ermöglichen.

Zum Ermitteln eines Kurzschlusses F10 oder einer Unterbrechung F10 wird vorzugsweise die Aktorspannung up und der Aktorstrom ip ausgewertet, da die Differenz des Aktorstroms ip bei einem fehlerfreien Funktionsszustand OK vom Aktorstrom ip bei einer Unterbrechnung F10 und die Differenz der Aktorspannung up bei einem fehlerfreien Funktionsszustand OK von der Aktorspannung up bei einem Kurzschluß F30 groß genug ist, um durch Wahl geeigneter Schwellwerte eine sichere Unterscheidung der Funktionszustände auch bei geringer Meßgenauigkeit zu ermöglichen.

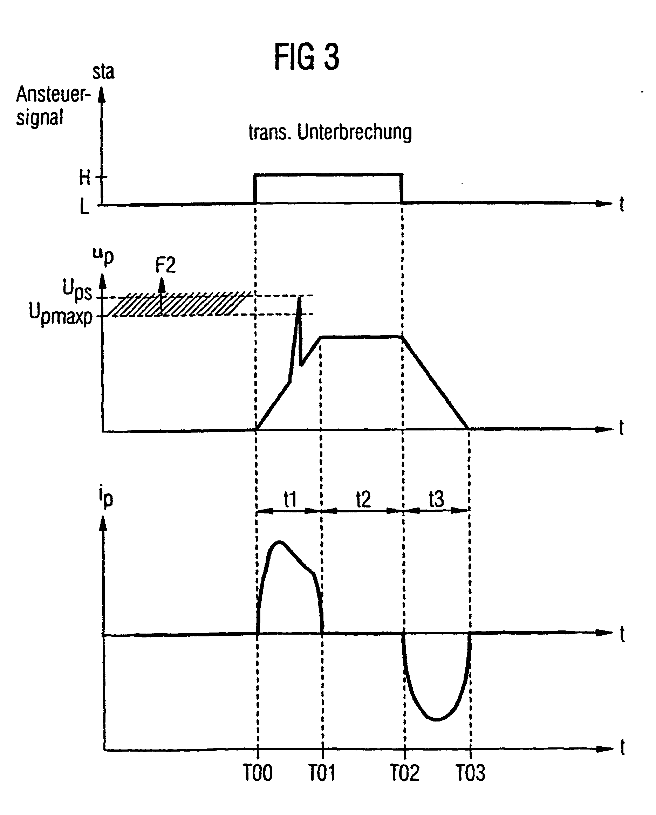

Aus dem Spannungsverlauf der Aktorspannung up in Figur 3, die während der Anstiegszeit t1 gemessen wird, wird auf eine kurzzeitige Unterbrechung F2 der Kontaktbahnen im Aktor Pm geschlossen, was zu einer Verzögerung in der Auslenkung des Aktors Pm und einem verzögerten Einspritzbeginn führt. Bei Auftreten dieses Fehlers bewirkt die kurzzeitige Unterbrechung während der Anstiegszeit t1 eine kurzeitige Spannungsüberhöhung der Aktorspannung up in Form einer Aktorspitzenspannung Ups, die über einer vorgegebenen oberen Spitzenspannung Upsmax liegt. Durch die Induktivität der Umschwingspule Lk in der Umladeschaltung Us resultiert die Spannungsüberhöhung. Die Aktorspitzenspannung Ups wird in einem Spitzenwertgleichrichter SWG erfaßt und mit einer vorgegebenen oberen Spitzenspannung Upsmax verglichen und ausgewertet. Die kurzzeitige Unterbrechung kann während der Anstiegszeit t1 oder der Abfallzeit t3 auftreten, wodurch der Aktor verzögert ausgelenkt wird bzw. verzögert in seine Ruheposition zurückkehrt und sich somit Öffnen und Schließen des Einspritzventil verzögert.

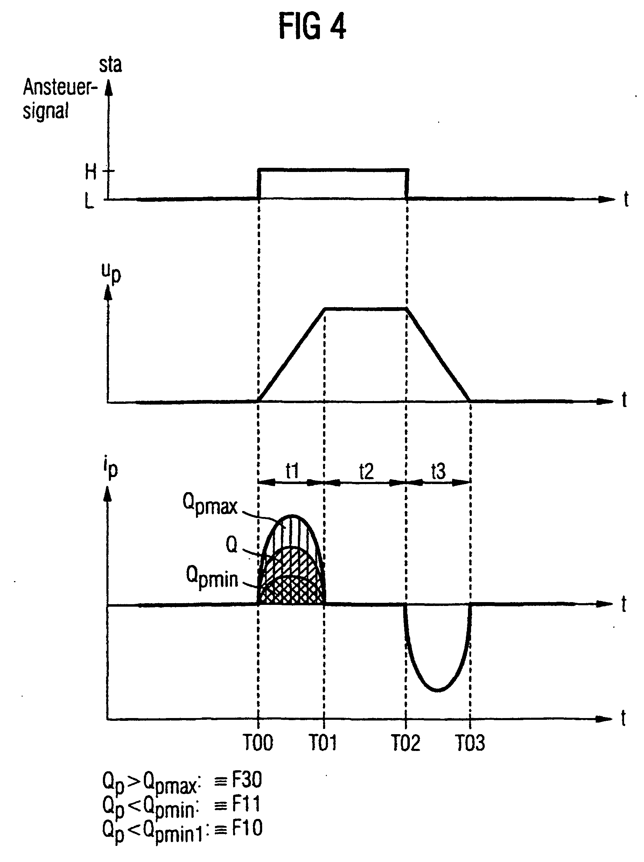

In Figur 4 wird die während des Umladevorgangs auf den Aktor Pm aufgebrachte Aktorladung Qp dargestellt, die dem Integral des Aktorstroms ip über die Anstiegszeit t1 entspricht und die mit einem unteren und einem oberen Ladungswert Qpmin, Qpmax verglichen und ausgewertet wird. Ein Überschreiten des oberen Ladungswertes Qpmax deutet auf einen Kurzschluß F3, ein Unterschreiten des unteren Ladungswertes Qpmin auf eine Unterbrechung F10. Eine genauere Auswertung der Fehlerarten ist durch die Einführung weiterer vorgegebener oberer und unterer Ladungswerte möglich, wie in den vorherigen Figuren äquivalent zu den Aktorstrom- und Aktorspannungsvergleichswerten beschrieben wurde.

In einer weiteren Ausbildungsform wird die Aktorladung Qp zum Ermitteln einer Unterbrechung F10 ausgewertet, da die Differenz der Aktorladung Qp bei einem fehlerfreien Funktionsszustand OK von der Aktorladung Qp bei einer Unterbrechnung F10 groß genug ist, um durch Wahl geeigneter Schwellwerte eine sichere Unterscheidung der Funktionszustände auch bei geringer Meßgenauigkeit zu ermöglichen.

Der Funktionszustand und die Fehlerarten können durch Auswerten von einer oder mehrerer der drei Größen Aktorspannung up, Aktorstrom ip und Aktorladung Qp ermittelt werden.

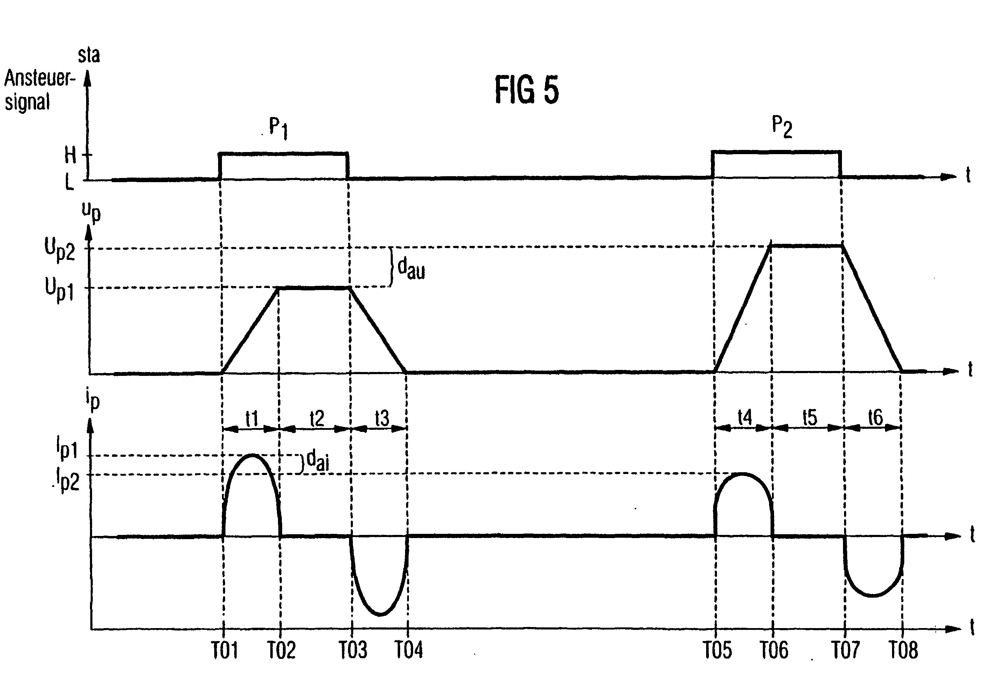

Aktoren weisen eine geringe Bauteiletoleranz von etwa 5 % der Aktorkapazität auf. In aufeinanderfolgenden Ansteuervorgängen werden Aktorspannungs-, Aktorstrom - oder Aktorladungswerte up, ip, Qp mehrerer Aktoren Pm, Pm+1, .. erfaßt und miteinander verglichen. In Figur 5 sind die Aktorspannungs- und die Aktorstromabläufe up, ip zweier Aktoren P1 und P2 in aufeinanderfolgenden Ansteuervorgängen dargestellt. Anhand der Auswertung des gemessenen ersten und zweiten Spannungswertes Up1,Up2 in zwei aufeinanderfolgenden Ansteuervorgängen wird beispielhaft das Auswertverfahren erläutert: Die Spannungsabweichung dau ist die Spannungsdifferenz zwischen den Spanungswerten Up1 und Up2 und liegt innerhalb eines vorgegebenen Toleranzbandes, wenn ein fehlerfreien Funktionszustand OK vorliegt, und außerhalb, wenn ein Fehler vorliegt. Entsprechend obiger Ausführung wird die Stromabweichung dai als Differenz zweier nacheinander gemessenen Stromwerte, dem ersten und dem zweiten Stromwert Ip1, Ip2, gebildet und ausgewertet.

Da in der Praxis bei einer vorgegebenen Anzahl von Aktoren P1 bis Pm nur eine geringe Anzahl von Aktoren gleichzeitig ausfallen, ist es möglich, Vergleiche von hintereinander abfolgenden Messungen unterschiedlicher Aktoren zu bilden und über eine Mehrheitsentscheidung den fehlerhaften Aktor zu entdekken, wobei durch Auswerten der Spannungsabweichung dau die Fehlerart feststellbar ist. Entsprechend kann der Aktorscheitelstrom Ips oder die Aktorladung Qp mehrerer Aktoren miteinander verglichen und zur Ermittlung des Funktionszustandes ausgewertet werden.

Die Aktorkapazität ist abhängig von der Aktortemperatur Tp. Zur Kompensation dieser Abhängigkeit werden die vorgegebenen Spannungs-, Strom- und Ladungswerte Upmax, Upmax1, Upmin, Upmaxp, Ipmin, Ipmin1, Ipmax, Qpmin, Qpmax in Abhängigkeit von der Aktortemperatur Tp angepaßt. Die Aktortemperatur Tp kann z.B. über einen oder mehrere Temperatursensoren ermittelt werden.

Figur 6 zeigt die Anordnung zur Durchführung des Verfahrens zum Ansteuern und zur Diagnose eines Aktors Pm und einer dazugehörigen Ansteuerschaltung. Die Ansteuerschaltung zur Ansteuerung eines Aktors Pm weist eine Energiequelle V auf, die einen oder mehrere Ladekondensatoren Cj mit Energie versorgt. Über eine oder mehrere Umschwingspulen Lk wird der auf eine vorgegebene Ladespannung aufgeladene Ladekondensator Cj auf einen Aktor Pm umgeladen. Die Umschwingschaltung weist Dioden Dl und Umladeschalter Xi auf; die von einem Steuergerät ST derart angesteuert werden, daß der Aufladevorgang der Ladekondensatoren Cj aus der Energiequelle V und das Umladen einer vorgegebenen Energie oder einer vorgegebenen Ladung auf einen Aktor Pm durchgeführt wird. Jedem Aktor Pm ist ein Auswahlschalter Ym zugeordnet, wobei die Auswahlschalter Ym von dem Steuergerät ST über die Auswahlsignale Am entsprechend der Reihenfolge der Einspritzvorgänge in der Brennkraftmaschine gesteuert werden.

Das Steuergerät ST kann Teil eines nicht näher dargestellten mikroprozessorgesteuerten Motorsteuergeräts sein.

Das Steuergerät ST wird von einer mikroprozessorgesteuerten Logikeinheit LU gesteuert. Dem Steuergerät ST werden folgende Eingangssignale zugeführt:
- Ein Ansteuersignal sta, das den Ansteuervorgang eines Aktors Pm auslüst und beendet,
- die gemessene Aktorspannung up,
- den Aktorstrom ip, der vorzugsweise über einen Meßwiderstand in der minuspolseitigen Leitung zwischen Aktor Pm und Umsteuerschaltung Us gemessen wird,
- die Aktortemperatur Tp.

Das Steuergerät ST weist folgende Ausgangssignale auf:
- Steuersignale Ai, die die Umladeschalter Xi der Umladeschaltung Us ansteuern,
- Auswahlsignale Am, die die Auswahlschalter Ym zur Auswahl eines Aktors Pm ansteuern,
- ein Funktionssignal Fs, das den Funktionszustand ausgibt, vorzugsweise an das externe Motorsteuergerät, das eine Reaktion auf den Fehler einleitet.

Das Steuergerät ST weist folgende Komponenten auf:
- Eine Logikeinheit LU, die die Ausgangssignale Ai, Am, Fs ausgibt, wobei das Funktionssignal Fs vorzugsweise dem externen Motorsteuergerät zur weiteren Fehlerbehandlung zugeführt wird,
- ein Spannungskomparator K1, der die Aktorspannung up mit den vorgegebenen oberen und unteren Spannungswerten Upmin, Upmax, Upmax1 vergleicht und das Ergebnis des Vergleichs an die Logikeinheit LU weitergibt,
- einen Spitzenwertkomparator K3, der die Aktorspitzenspannung Ups mit einer vorgegebenen, oberen Spitzenspannung Upsmax vergleicht und das Ergebnis an die Logikeinheit LU weitergibt, wobei die Aktorspitzenspannung Ups mit einem Spitzenwertgleichrichter SWG aus der Aktorspannung up ermittelt wird,
- einen A/D-Wandler, der die eingehende Aktorspannung up in digitale Werte umwandelt und sie zur Logikeinheit LU weiterleitet. Der A/D-Wandler dient dazu, der Logikeinheit LU die Aktorspannung up während der Haltezeit t2 zur weiteren Verarbeitung zur Verfügung zu stellen. Mit den damit ermittelten Aktorspannungswerten up ist eine verfeinerte Differenzierung und Unterscheidung der der Fehlerarten möglich. Der Einsatz eines D/A-Wandlers kann vorteilhaft den Hardwareaufwand durch Einsparen von Komparatoren redu-zieren, wobei der Vergleich digital als Teil des Programmablaufes in der Logikeinheit LU stattfinden kann. Weiterhin ist durch Einführen weiterer vorgegebener Schwellwerte vorteilhaft eine verfeinerte Differenzierung nach weiteren Fehlerarten möglich,
- ein Stromkomparator K2, der den eingehenden Aktorscheitelstrom Ips mit den vorgegebenen unteren und oberen Stromwerten Ipmin, Ipmax, Ipmin1 vergleicht, wobei der Aktorscheitelstrom Ips durch den Maximalwertbildner MAX aus dem Aktorstrom Ip erzeugt wird. Das Ergebnis des Vergleichs wird der Logikeinheit LU zugeführt,
- ein Ladungskomparator K4, der die dem Aktor Pm zugeführte Aktorladung Qp mit einem vorgegebenen oberen und unteren Ladungswert Qpmax, Qpmin vergleicht, wobei ein Integrierer INT das Integrals des Aktorstroms ip über die Zeit t, vorzugsweise über die Anstiegszeit t1, bildet. Das Ergebnis des Vergleichs wird der Logikeinheit LU zugeführt. Dieser Schaltugszweig kann den Schaltungszweig mit dem Maximalwertbildner MAX ersetzen, in dem der Aktorscheitelstrom Ips ermittelt wird.
- einem Konstantenspeicher KF, der den Komparatoren K1 bis K4 vorgegebene Vergleichswerte zu führt.

In einer weiteren Ausführungform stellt ein A/D-Wandler der Logikeinheit LU die Aktorladung Qp oder den Aktorscheitelstrom Ips in digitalisierter Form zur Verfügung. Dadurch wird vorteilhaft eine Feinauswertung der Fehlerarten F10, F11 und F30 ermöglicht.

Die Logikeinheit LU gibt Ansteuersignale Am, die die Auswahlschalter Ym zur Auswahl eines Aktors Pm steuern, und Steuersignale Ai an die Umladeschaltung Us aus, mit denen über die Umladeschalter Xi der Verlauf der Ansteuerung eines Aktors Pm gesteuert wird.

Das Funktionssignal Fs gibt den Funktionszustand an die externe Motorsteuereinheit aus. Das Einleiten einer Reaktion auf einen Fehler kann wahlweise in der externen Motorsteuereinheit oder in der Logikeinheit LU des Steuergerätes ST durchgeführt werden. Ein Reaktion kann z.B. darin bestehen, nach Auftreten einer Fehlerart den als fehlerhaft erkannten Aktor Pm und den betreffenden Zylinder abzuschalten, d.h. keine Ansteuerimpulse an den betreffenden fehlerhaften Aktor Pm auszugeben. Dadurch ist vorteilhaft ein eingeschränktes Funktionieren der Brennkraftmaschine trotz vorhandenen Defektes möglich, um z.B. das Fahrzeug bis zur nächsten Werkstatt zu fahren.

Eine fehlertolerante Reaktion auf sporadisch auftretende oder durch Störimpulse verfälschte Meßergebnisse ist möglich, indem erst nach Auftreten von mehr als einer vorgegebenen Anzahl von Fehlern einer Fehlerart innerhalb einer vorgegebenen Fehlerzeit eine Reaktion eingeleitet wird. Dadurch wird die Wirkung äußerer Störeinflüsse vorteilhaft verringert. Die Anzahl der irrtümlich oder kurzzeitig aufgetretenen Fehler kann zusätzlich in der Logikeinheit LU gespeichert werden, um z.B. beim nächsten Werkstattaufenthalt ausgewertet zu werden.

Bei sehr kurzen Einspritzzeiten, wie sie z.B. im Kraftstoffeinspritzventil bei einer Piloteinspritzung mit nachfolgender Haupteinspritzung auftreten können, kann die Haltezeit t2 gegen Null gehen. Durch Anpassen der vorgegebenen Spannungs-, Strom- und Ladungswerte Upmax, Upmax1, Upmin, Upmaxp, Ipmin, Ipmin1, Ipmax, Qpmin, Qpmax können dynamische Rückwirkungen von der Mechanik auf den Aktor Pm vorteilhaft kompensiert werden.

## Patentansprüche

1. Verfahren zur Diagnose eines kapazitiven Aktors (Pm) und einer dazugehörigen Ansteuerschaltung, wobei auf den Aktor (Pm) von einem Ladekondensator (Cj) über eine Umschwingspule (Lk) eine vorgebbare Energie übertragen wird, und
aus der Abweichung mindestens einer der ermittelten Größen
• Aktorspannung (up),
• Aktorstroms (ip) oder
• Aktor ladung (Qp)
von Bezugswerten (Upmin, Upmax, Upmax1, Upmaxp, Ipmin, Ipmax, Ipmin1, Qmin, Qmax) auf den Funktionszustand (OK, F10, F11, F2, F31) des Aktors (Pm) oder der dazugehörigen Ansteuerschaltung geschlossen wird, und
bei einer den unteren Spannungswert (Upmin) unterschreitenden Aktorspannung (up) auf einen Kurzschluß (F30) der elektrischen Verbindung innerhalb des Aktors (Pm) oder zwischen der Ansteuerschaltung und dem Aktor (Pm) geschlossen wird, und
bei einem einen weiteren unteren Stromwert (Ipmin1) unterschreitenden Aktorscheitelstrom (Ips) auf eine Unterbrechung (F10) der elektrischen Verbindung innerhalb des Aktors (Pm) oder zwischen der Ansteuerschaltung und dem Aktor (Pm) geschlossen wird.

2. Verfahren nach Anspruch 1, **dadurch gekennzeichnet, daß** bei einer zwischen einem unterem Spannungswert (Upmin) und einem oberen Spannungswert (Upmax) liegenden Aktorspannung (up) auf einen fehlerfreien Funktionszustand (OK) geschlossen wird.

3. Verfahren nach einem der vorhergehenden Ansprüche, **dadurch gekennzeichnet,**
**daß** bei einer den oberen Spannungswert (Upmax) überschreitenden Aktorspannung (up) auf eine zu geringe Aktorkapazität (F11) geschlossen wird.

4. Verfahren nach einem der vorhergehenden Ansprüche, **dadurch gekennzeichnet,**
**daß** bei einer einen weiteren oberen Spannungswert (Upmax1) überschreitenden Aktorspannung (up) auf eine Unterbrechung (F10) der elektrischen Verbindung innerhalb des Aktors (Pm) oder zwischen der Ansteuerschaltung und dem Aktor (Pm) geschlossen wird.

5. Verfahren nach einem der vorhergehenden Ansprüche, **dadurch gekennzeichnet,**
**daß** die Aktorspannung (up) während einer Haltezeit (t2) gemessen wird.

6. Verfahren nach einem der vorhergehenden Ansprüche, **dadurch gekennzeichnet,**
**daß** während einer Anstiegszeit (t1) die Aktorspannung (up) gemessen wird, und
**daß** bei einer eine obere Spitzenspannung (Upmaxp) überschreitenden Aktorspannung (up) auf eine kurzzeitige Unterbrechung (F2) der elektrischen Verbindung innerhalb des Aktors (Pm) während des Auslenkvorgangs des Aktors (Pm)geschlossen wird.

7. Verfahren nach einem der vorhergehenden Ansprüche, **dadurch gekennzeichnet,**
**daß** während der Anstiegszeit (t1) der Aktorscheitelstrom (Ips) als Maximalwert des Aktorstroms (ip) ermittelt wird.

8. Verfahren nach einem der vorhergehenden Ansprüche, **dadurch gekennzeichnet,**
**daß** bei einem zwischen einem unterem Stromwert (Ipmin) und einem oberen Stromwert (Ipmax) liegenden Aktorscheitelstrom (Ips) auf einen korrekten Funktionszustand (OK) geschlossen wird.

9. Verfahren nach einem der vorhergehenden Ansprüche, **dadurch gekennzeichnet,**
**daß** bei einem den unteren Stromwert (Ipmin) unterschreitenden Aktorscheitelstrom (Ips) auf eine zu geringe Aktorkapazität (F11) geschlossen wird.

10. Verfahren nach einem der vorhergehenden Ansprüche, **dadurch gekennzeichnet,**
**daß** bei einem den oberen Stromwert (Ipmax) überschreitenden Aktorscheitelstrom (Ips) auf einen Kurzschluß (F30) der elektrischen Verbindung innerhalb des Aktors (Pm) oder zwischen der Ansteuerschaltung und dem Aktor (Pm) geschlossen wird.

11. Verfahren nach Anspruch 1, **dadurch gekennzeichnet,**
**daß** die Aktorladung (Qp) während einer Anstiegszeit (t1) von einem Ladekondensator (C) auf den Aktor (Pm) ermittelt wird.

12. Verfahren nach einem der Ansprüche 1 oder 11, **dadurch gekennzeichnet,**
**daß** bei einer zwischen einem unterem Ladungswert (Qpmin) und einem oberen Ladungswert (Qpmax) liegenden Aktorladung (Qp) auf einen korrekten Funktionszustand (OK) geschlossen wird.

13. Verfahren nach einem der Ansprüche 1, 11 oder 12, **dadurch gekennzeichnet,**
**daß** bei einer den unteren Ladungswert (Qpmin) unterschreitenden Aktorladung (Qp) auf eine zu geringe Aktorkapazität (F11) geschlossen wird.

14. Verfahren nach einem der Ansprüche 1, 11 bis 13, **dadurch gekennzeichnet,**
**daß** bei einer einen weiteren unteren Ladungswert (Qpmin1) unterschreitenden Aktorladung (Qp) auf eine Unterbrechung (F10) der elektrischen Verbindung innerhalb des Aktors (Pm) oder zwischen der Ansteuerschaltung und dem Aktor (Pm) geschlossen wird.

15. Verfahren nach einem der Ansprüche 1, 11 bis 14, **dadurch gekennzeichnet,**
**daß** bei einer den oberen Ladungswert (Qpmax) überschreitenden Aktorladung (Qp) auf einen einen Kurzschluß (F30) der elektrischen Verbindung innerhalb des Aktors (Pm) oder zwischen der Ansteuerschaltung und dem Aktor (Pm) geschlossen wird.

16. Verfahren nach einem der vorhergehenden Ansprüche, **dadurch gekennzeichnet,**
**daß** die Bezugswerte (Upmin, Upmax, Upmax1, Upmaxp, Ipmin, Ipmax, Ipmin1, Qmin, Qmax) von der Aktortemperatur (Tp) abhängig sind.

17. Verfahren nach einem der vorhergehenden Ansprüche, **dadurch gekennzeichnet,**
**daß** nach Auftreten von mehr als einer vorgegebenen Anzahl von Fehlern einer Fehlerart (F10, F11, F2, F20, F30, F31) innerhalb einer vorgegebenen Fehlerzeit eine Reaktion auf den Fehler eingeleitet wird.

18. Verfahren nach einem der vorhergehenden Ansprüche, **dadurch gekennzeichnet,**
**daß** die Abweichung (dau, dai) der ermittelten Werte der Aktorspannung (up), des Aktorstroms (ip) oder der Aktorladung (Qp) eines Aktors (Pm) in einem Ansteuervorgang von den Werten eines Aktors (P(m+1)) in einem nachfolgenden Ansteuervorgang ermittelt wird, und
**daß** bei Überschreiten der Abweichung (dau, dai) von einem vorgegebenen Toleranzband auf einen Fehler geschlossen wird.

19. Anordnung zur Durchführung des Verfahrens nach Anspruch 1, **dadurch gekennzeichnet,**
**daß** die Ansteuerschaltung zur Ansteuerung eines Aktors (Pm) aufweist:
- eine Energiequelle (V),
- eine Umladeschaltung (Us) mit
• einem oder mehreren Ladekondensatoren (Cj),
• einer oder mehreren Umschwingspulen (Lk),
• Umladeschaltern (Xi),
• Dioden (Dl),
• Auswahlschaltern (Ym),
- Aktoren (Pm),
- ein mikroprozessorgesteuertes Steuergerät (ST) das die Arbeitsschritte des Verfahrens zur Diagnose eines kapazitiven Aktors (Pm) durchführt und
folgende Eingangssignale aufweist:
• ein Ansteuersignal (sta), das den Ansteuervorgang eines Aktors (Pm) steuert,
• die Aktorspannung (up) oder den Aktorstrom (ip) und
• die Aktortemperatur (Tp),
folgende Ausgangssignale aufweist:
• Steuersignale (Ai), die die Umladeschalter (Xi) der Umladeschaltung (Us) ansteuern,
• Auswahlsignale (Am), die die Auswahlschalter (Ym) zur Auswahl eines Aktors (Pm) ansteuern,
• ein Funktionssignal (Fs), das den Funktionszustand ausgibt, und
folgende Komponenten aufweist:
• eine Logikeinheit (LU), die mit den Ausgangssignalen (Ai, Am) die Umladeschalter (Xi) und die Auswahlschal-ter (Ym) ansteuert,
• Komparatoren (K1, K2, K3, K4), die die Eingangssignale (up, ip) mit den Bezugswerten (Upmin, Upmax, Upmax1, Upmaxp, Ipmin, Ipmax, Ipmin1, Qmin, Qmax) vergleichen, und deren Ausgangssignale in die Logikeinheit (LU) eingehen,
• einen Konstantenspeicher (KS), der den Komparatoren (K1, K2, K3, K4) Bezugswerte (Upmin, Upmax, Upmax1, Upmaxp, Ipmin, Ipmax, Ipmin1, Qmin, Qmax) liefert.

20. Anordnung zur Durchführung des Verfahrens nach Anspruch 19, **dadurch gekennzeichnet,**
**daß** das Steuergerät (ST) einen Analog-Digital-Wandler (A/D) aufweist, dem die Aktorspannung (up) zugeführt wird und der die digitalisierten Werte der Aktorspannung (up) an die nachfolgende Logikeinheit (LU) ausgibt.

21. Anordnung zur Durchführung des Verfahrens nach einem der Ansprüche 19 oder 20, **dadurch gekennzeichnet,**
**daß** das Steuergerät (ST) einen Spitzenwertkomparator (K3) aufweist, der eine Aktorspitzenspannung (Ups) mit einer vorgegebenen oberen Spitzenspannung (Upsmax) vergleicht und das Vergleichsergebnis an die Logikeinheit (LU) ausgibt, wobei ein Spitzenwertgleichrichter (SWG) aus der eingehenden Aktorspannung (up) die Aktorspitzenspannung (Ups) ermittelt.

22. Anordnung zur Durchführung des Verfahrens nach einem der Ansprüche 19 bis 21, **dadurch gekennzeichnet,**
**daß** das Steuergerät (ST) einen Spannungskomparator (K1) aufweist, der die Aktorspannung (up) mit vorgegebenen Spannungswerten,
• den unteren Spannungswerten (Upmin) und
• den oberen Spannungswerten (Upmax, Upmax1),
vergleicht und das Vergleichsergebnis an die Logikeinheit (LU) ausgibt.

23. Anordnung zur Durchführung des Verfahrens nach einem der Ansprüche 19 bis 22, **dadurch gekennzeichnet,**
**daß** das Steuergerät (ST) einen Stromkomparator (K2) aufweist, der den Aktorscheitelstrom (Ips) mit den vorgegebenenunteren Stromwerten (Ipmin, Ipmin1) und dem oberen Stromwert (Ipmax) vergleicht und das Vergleichsergebnis an die Logikeinheit (LU) ausgibt, wobei ein Maximalwertbildner (MAX) aus dem eingehenden Aktorstrom (ip) den Aktorscheitelstrom (Ips) ermittelt.

24. Anordnung zur Durchführung des Verfahrens nach einem der Ansprüche 19 bis 23, **dadurch gekennzeichnet,**
**daß** das Steuergerät (ST) einen Ladungskomparator (K4) aufweist, der die auf den Aktor (Pm) übertragene Ladung (Qp) mit vorgegebenen Ladungswerten,
• dem unteren Ladungswert (Qpmin) und
• dem oberen Ladungswert (Qpmax),
vergleicht und das Vergleichsergebnis an die Logikeinheit (LU) ausgibt, wobei ein Integrierer (INT) aus der Integration des eingehenden Aktorstroms (ip) über die Zeit (t) die Aktorladung (Qp) ermittelt.

## Claims

1. Method for diagnosis of a capacitive actuator (Pm) and an associated drive circuit, wherein a predeterminable amount of energy is transmitted to the actuator (Pm) from a charge-storage capacitor (Cj) via a ringing coil (Lk) and the functional status (OK, F10, F11, F2, F31) of the actuator (Pm) or of the associated drive circuit is deduced from the discrepancy between at least one of the following determined variables
• actuator voltage (up)
• actuator current (ip) or
• actuator charge (Qp)
and reference values (Upmin, Upmax, Upmax1, Upmaxp, Ipmin, Ipmax, Ipmin1, Qmin, Qmax) and
if the actuator voltage (up) is less than the lower voltage value (Upmin), a short-circuit (F30) of the electrical connection within the actuator (Pm) or between the drive circuit and the actuator (Pm) is deduced, and
if the actuator peak current (Ips) is less than a further lower current value (Ipmin1), an interruption (F10) in the electrical connection within the actuator (Pm) or between the drive circuit and the actuator (Pm) is deduced.

2. Method according to Claim 1, **characterized**
**in that**, if the actuator voltage (up) is between a lower voltage value (Upmin) and an upper voltage value (Upmax), a serviceable functional status (OK) is deduced.

3. Method according to one of the preceding claims, **characterized**
**in that**, if the actuator voltage (up) is greater than the upper voltage value (Upmax), an excessively low actuator capacitance (F11) is deduced.

4. Method according to one of the preceding claims, **characterized**
**in that**, if the actuator voltage (up) is greater than a further upper voltage value (Upmax1), an interruption (F10) in the electrical connection within the actuator (Pm) or between the drive circuit and the actuator (Pm) is deduced.

5. Method according to one of the preceding claims, **characterized**
**in that** the actuator voltage (up) is measured during a hold time (t2).

6. Method according to one of the preceding claims, **characterized**
**in that** the actuator voltage (up) is measured during a rise time (t1), and
**in that**, if the actuator voltage (up) is greater than an upper peak voltage (Upmaxp), a short-term interruption (F2) in the electrical connection within the actuator (Pm) during the deflection process of the actuator (Pm) is deduced.

7. Method according to one of the preceding claims, **characterized**
**in that** the actuator peak current (Ips) during the rise time (t1) is determined as the maximum value of the actuator current (ip).

8. Method according to one of the preceding claims, **characterized**
**in that**, if the actuator peak current (Ips) is between a lower current value (Ipmin) and an upper current value (Ipmax), a correct functional status (OK) is deduced.

9. Method according to one of the preceding claims, **characterized**
**in that**, if the actuator peak current (Ips) is less than the lower current value (Ipmin), an excessively low actuator capacitance (F11) is deduced.

10. Method according to one of the preceding claims, **characterized**
**in that**, if the actuator peak current (Ips) is greater than the upper current value (Ipmax), a short-circuit (F30) in the electrical connection within the actuator (Pm) or between the drive circuit and the actuator (Pm) is deduced.

11. Method according to Claim 1, **characterized**
**in that** the actuator charge (Qp) is determined during a rise time (t1) from a charge-storage capacitor (C) to the actuator (Pm).

12. Method according to one of Claims 1 or 11, **characterized**
**in that**, if the actuator charge (Qp) is between a lower charge value (Qpmin) and an upper charge value (Qpmax), a correct functional status (OK) is deduced.

13. Method according to one of Claims 1, 11 or 12, **characterized**
**in that**, if the actuator charge (Qp) is less than the lower charge value (Qpmin), an excessively low actuator capacitance (F11) is deduced.

14. Method according to one of Claims 1, 11 to 13, **characterized**
**in that**, if the actuator charge (Qp) is less than a further lower charge value (Qpmin1), an interruption (F10) in the electrical connection within the actuator (Pm) or between the drive circuit and the actuator (Pm) is deduced.

15. Method according to one of Claims 1, 11 to 14, **characterized**
**in that**, if the actuator charge (Qp) is greater than the upper charge value (Qpmax) a short-circuit (F30) of the electrical connection within the actuator (Pm) or between the drive circuit and the actuator (Pm) is deduced.

16. Method according to one of the preceding claims, **characterized**
**in that** the reference values (Upmin, Upmax, Upmax1, Upmaxp, Ipmin, Ipmax, Ipmin1, Qmin, Qmax) are dependent on the actuator temperature (Tp).

17. Method according to one of the preceding claims, **characterized**
**in that**, after the occurrence of more than a predetermined number of faults of a fault type (F10, F11, F2, F20, F30, F31) within a predetermined fault time, a reaction to the fault is initiated.

18. Method according to one of the preceding claims, **characterized**
**in that** the discrepancy (dau, dai) between the determined values of the actuator voltage (up), of the actuator current (ip) or of the actuator charge (Qp) of an actuator (Pm) in a drive process from the values of an actuator (P (m+1)) in a subsequent drive process is determined, and in that, if the discrepancy (dau, dai) exceeds a predetermined tolerance band, a fault is deduced.

19. Arrangement for carrying out the method according to Claim 1, **characterized**
**in that** the drive circuit for driving an actuator (Pm) has:
- an energy source (V),
- a charge-reversal circuit (Us) having
• one or more charge-storage capacitors (Cj),
• one or more ringing coils (Lk),
• charge-reversal switches (Xi),
• diodes (D1),
• selection switches (Ym),
- actuators (Pm),
- a microprocessor-controlled controller (ST) which carries out the process steps of the method for diagnosis of a capacitive actuator (Pm) and
has the following input signals:
• a drive signal (sta), which controls the drive process of an actuator (Pm),
• the actuator voltage (up) or the actuator current (ip) and
• the actuator temperature (Tp),
has the following output signals:
• control signals (Ai) which drive the charge-reversal switches (Xi) in the charge-reversal circuit (Us),
• selection signals (Am), which drive the selection switches (Ym) for selection of an actuator (Pm),
• a function signal (Fs), which outputs the functional status, and
has the following components:
• a logic unit (LU) whose output signals (Ai, Am) drive the charge-reversal switches (Xi) and the selection switches (Ym),
• comparators (K1, K2, K3, K4) which compare the input signals (up, ip) with the reference values (Upmin, Upmax, Upmax1, Upmaxp, Ipmin, Ipmax, Ipmin1, Qmin, Qmax) and whose output signals are passed to the logic unit (LU),
• a constant memory (KS), which supplies the comparators (K1, K2, K3, K4) with reference values (Upmin, Upmax, Upmax1, Upmaxp, Ipmin, Ipmax, Ipmin1, Qmin, Qmax).

20. Arrangement for carrying out the method according to Claim 19, **characterized**
**in that** the controller (ST) has an analogue/digital converter (A/D) to which the actuator voltage (up) is supplied and which outputs the digitized values of the actuator voltage (up) to the downstream logic unit (LU).

21. Arrangement for carrying out the method according to one of Claims 19 or 20, **characterized**
**in that** the controller (ST) has a peak value comparator (K3) which compares an actuator peak voltage (Ups) with a predetermined upper peak voltage (Upsmax) and outputs the comparison result to the logic unit (LU), with a peak value detector (SWG) using the incoming actuator voltage (up) to determine the actuator peak voltage (Ups).

22. Arrangement for carrying out the method according to one of Claims 19 to 21, **characterized**
**in that** the controller (ST) has a voltage comparator (K1) which compares the actuator voltage (up) with predetermined voltage values,
• the lower voltage values (Upmin) and
• the upper voltage values (Upmax, Upmax1),
and outputs the comparison result to the logic unit (LU).

23. Arrangement for carrying out the method according to one of Claims 19 to 22, **characterized**
**in that** the controller (ST) has a current comparator (K2) which compares the actuator peak current (Ips) with the predetermined lower current values (Ipmin, Ipmin1) and the upper current value (Ipmax), and outputs the comparison result to the logic unit (LU), with a maximum-value forming device (MAX) determining the actuator peak current (Ips) from the incoming actuator current (ip).

24. Arrangement for carrying out the method according to one of Claims 19 to 23, **characterized**
**in that** the controller (ST) has a charge comparator (K4) which compares the charge (Qp) transmitted to the actuator (Pm) with predetermined charge values,
• the lower charge value (Qpmin) and
• the upper charge value (Qpmax)
and outputs the comparison result to the logic unit (LU), with an integrator (INT) using the integration of the incoming actuator current (ip) over the time (t) to determine the actuator charge (Qp).

## Revendications

1. Procédé pour diagnostiquer un actionneur capacitif (Pm) et un circuit d'excitation associé, une énergie prédéterminable étant transmise à l'actionneur (Pm) par un condensateur de charge (Cj) par l'intermédiaire d'une bobine à courant inverse (Lk) et
il est conclu à l'état fonctionnel (OK, F10, F11, F2, F31) de l'actionneur (Pm) ou du circuit d'excitation associé à partir de l'écart entre au moins l'une des grandeurs déterminées suivantes:
• tension d'actionneur (up),
• courant d'actionneur (ip) ou
• charge d'actionneur (Qp)
et des valeurs de référence (Upmin, Upmax, Upmax1, Upmaxp, Ipmin, Ipmax, Ipmin1, Qmin, Qmax) et
il est conclu à un court-circuit (F30) de la connexion électrique à l'intérieur de l'actionneur (Pm) ou entre le circuit d'excitation et l'actionneur (Pm) dans le cas d'une tension d'actionneur (up) qui dépasse par le bas la valeur de tension inférieure (Upmin) et
il est conclu à une interruption (F10) de la connexion électrique à l'intérieur de l'actionneur (Pm) ou entre le circuit d'excitation et l'actionneur (Pm) dans le cas d'un courant de crête d'actionneur (Ips) qui dépasse par le bas une autre valeur de courant inférieure (Ipmin1).

2. Procédé selon la revendication 1, **caractérisé en ce qu'**il est conclu à un état fonctionnel sans défaillance (OK) dans le cas d'une tension d'actionneur (up) située entre une valeur de tension inférieure (Upmin) et une valeur de tension supérieure (Upmax).

3. Procédé selon l'une des revendications précédentes, **caractérisé en ce qu'**il est conclu à une capacité de l'actionneur (F11) trop faible dans le cas d'une tension d'actionneur (up) qui dépasse par le haut la valeur de tension supérieure (Upmax).

4. Procédé selon l'une des revendications précédentes, **caractérisé en ce qu'**il est conclu à une interruption (F10) de la connexion électrique à l'intérieur de l'actionneur (Pm) ou entre le circuit d'excitation et l'actionneur (Pm) dans le cas d'une tension d'actionneur (up) qui dépasse par le haut une autre valeur de tension supérieure (Upmax1).

5. Procédé selon l'une des revendications précédentes, **caractérisé en ce que** la tension d'actionneur (up) est mesurée pendant un temps de maintien (t2).

6. Procédé selon l'une des revendications précédentes, **caractérisé en ce que** la tension d'actionneur (up) est mesurée pendant un temps de croissance (t1) et **en ce qu'**il est conclu à une interruption de courte durée (F2) de la connexion électrique à l'intérieur de l'actionneur (Pm) pendant l'opération de déviation de l'actionneur (Pm) dans le cas d'une tension d'actionneur (up) qui dépasse par le haut une tension de pointe supérieure (Upmaxp).

7. Procédé selon l'une des revendications précédentes, **caractérisé en ce que** le courant de crête d'actionneur (Ips) est déterminé en tant que valeur maximale du courant d'actionneur (Ip) pendant le temps de croissance (t1).

8. Procédé selon l'une des revendications précédentes, **caractérisé en ce qu'**il est conclu à un état fonctionnel correct (OK) dans le cas d'un courant de crête d'actionneur (Ips) situé entre une valeur de courant inférieure (Ipmin) et une valeur de courant supérieure (Ipmax).

9. Procédé selon l'une des revendications précédentes, **caractérisé en ce qu'**il est conclu à une capacité d'actionneur trop faible (F11) dans le cas d'un courant de crête d'actionneur (Ips) qui dépasse par le bas la valeur de courant inférieure (Ipmin).

10. Procédé selon l'une des revendications précédentes, **caractérisé en ce** qu"il est conclu à un court-circuit (F30) de la connexion électrique à l'intérieur de l'actionneur (Pm) ou entre le circuit d'excitation et l'actionneur (Pm) dans le cas d'un courant de crête d'actionneur (Ips) qui dépasse par le haut la valeur de courant supérieure (Ipmax).

11. Procédé selon la revendication 1, **caractérisé en ce que** la charge d'actionneur (Qp) est déterminée pendant un temps de croissance (t1) d'un condensateur de charge (C) vers l'actionneur (Pm).

12. Procédé selon l'une des revendications 1 ou 11, **caractérisé en ce qu'**il est conclu à un état fonctionnel correct (OK) dans le cas d'une charge d'actionneur (Qp) située entre une valeur de charge inférieure (Qpmin) et une valeur de charge supérieure (Qpmax).

13. Procédé selon l'une des revendications 1, 11 ou 12, **caractérisé en ce qu'**il est conclu à une capacité d'actionneur trop faible (F11) dans le cas d'une charge d'actionneur (Qp) qui dépasse par le bas la valeur de charge inférieure (Qpmin).

14. Procédé selon l'une des revendications 1, 11 à 13, **caractérisé en ce qu'**il est conclu à une interruption (F10) de la connexion électrique à l'intérieur de l'actionneur (Pm) ou entre le circuit d'excitation et l'actionneur (Pm) dans le cas d'une charge d'actionneur (Qp) qui dépasse par le bas une autre valeur de charge inférieure (Qpmin1).

15. Procédé selon l'une des revendications 1, 11 à 14, **caractérisé en ce qu'**il est conclu à un court-circuit (F30) de la connexion électrique à l'intérieur de l'actionneur (Pm) ou entre le circuit d'excitation et l'actionneur (Pm) dans le cas d'une charge d'actionneur (Qp) qui dépasse par le haut la valeur de charge supérieure (Qpmax).

16. Procédé selon l'une des revendications précédentes, **caractérisé en ce que** les valeurs de référence (Upmin, Upmax, Upmax1, Upmaxp, Ipmin, Ipmax, Ipmin1, Qmin, Qmax) sont fonction de la température de l'actionneur (Tp).

17. Procédé selon l'une des revendications précédentes, **caractérisé en ce qu'**une réaction à la défaillance est initialisée après la survenance de plus d'un nombre prédéterminé de défaillances d'un type de défaillance (F10, F11, F2, F20, F30, F31) dans un temps de défaillance prédéterminé.

18. Procédé selon l'une des revendications précédentes, **caractérisé en ce que** l'écart (dau, dai) entre les valeurs déterminées de la tension d'actionneur (up), du courant d'actionneur (ip) ou de la charge d'actionneur (Qp) d'un actionneur (Pm) dans une opération d'excitation et les valeurs d'un actionneur (P(m+1)) dans une opération d'excitation suivante est déterminé et **en ce qu'**il est conclu à une défaillance dans le cas où l'écart (dau, dai) dépasse une bande de tolérance prédéterminée.

19. Système pour exécuter le procédé selon la revendication 1, **caractérisé en ce que** le circuit d'excitation pour exciter un actionneur (Pm) comporte:
- une source d'énergie (V),
- un circuit de transfert de charge (Us) avec
• un ou plusieurs condensateurs de charge (Cj),
• une ou plusieurs bobines à courant inverse (Lk),
• des commutateurs de transfert de charge (Xi),
• des diodes (D1),
• des commutateurs de sélection (Ym),
- des actionneurs (Pm),
- un appareil de commande commandé par microprocesseur (ST), lequel effectue les étapes fonctionnelles du procédé pour diagnostiquer un actionneur capacitif (Pm) et
présente les signaux d'entrée suivants:
• un signal d'excitation (sta) qui commande l'opération d'excitation d'un actionneur (Pm),
• la tension d'actionneur (up) ou le courant d'actionneur (ip) et
• la température de l'actionneur (Tp),
présente les signaux de sortie suivants:
• des signaux de commande (Ai) qui excitent les commutateurs de transfert de charge (Xi) du circuit de transfert de charge (Us),
• des signaux de sélection (Am) qui excitent les commutateurs de sélection (Ym) pour la sélection d'un actionneur (Pm),
• un signal fonctionnel (Fs) qui émet l'état fonctionnel et
comporte les composants suivants:
• une unité logique (LU) qui excite les commutateurs de transfert de charge (Xi) et les commutateurs de sélection (Ym) avec les signaux de sortie (Ai, Am),
• des comparateurs (K1, K2, K3, K4) qui comparent les signaux d'entrée (up, ip) avec les valeurs de référence (Upmin, Upmax, Upmax1, Upmaxp, Ipmin, Ipmax, Ipmin1, Qmin, Qmax) et dont les signaux de sortie entrent dans l'unité logique (LU),
• une mémoire de constantes (KS) qui fournit des valeurs de référence (Upmin, Upmax, Upmax1, Upmaxp, Ipmin, Ipmax, Ipmin1, Qmin, Qmax) aux comparateurs (K1, K2, K3, K4).

20. Système pour exécuter le procédé, selon la revendication 19, **caractérisé en ce que** l'appareil de commande (ST) comporte un convertisseur analogique numérique (A/D) auquel est amenée la tension d'actionneur (up) et qui envoie les valeurs numérisées de la tension d'actionneur (up) à l'unité logique (LU) en aval.

21. Système pour exécuter le procédé, selon l'une des revendications 19 ou 20, **caractérisé en ce que** l'appareil de commande (ST) comporte un comparateur de valeur de pointe (K3) qui compare une tension de pointe d'actionneur (Ups) avec une tension de pointe supérieure (Upsmax) prédéterminée et envoie le résultat de la comparaison à l'unité logique (LU), un redresseur de valeur de pointe (SWG) déterminant la tension de pointe d'actionneur (Ups) à partir de la tension d'actionneur entrante (up).

22. Système pour exécuter le procédé, selon l'une des revendications 19 à 21, **caractérisé en ce que** l'appareil de commande (ST) comporte un comparateur de tension (K1) qui compare la tension d'actionneur (up) avec des valeurs de tension prédéterminées,
• les valeurs de tension inférieures (Upmin) et
• les valeurs de tension supérieures (Upmax, Upmax1)
et envoie le résultat de la comparaison à l'unité logique (LU).

23. Système pour exécuter le procédé, selon l'une des revendications 19 à 22, **caractérisé en ce que** l'appareil de commande (ST) comporte un comparateur de courant (K2) qui compare le courant de crête d'actionneur (Ips) avec les valeurs de courant inférieures (Ipmin, Ipmin1) prédéterminées et la valeur de courant supérieure (Ipmax) et envoie le résultat de la comparaison à l'unité logique (LU), un formateur de valeur maximale (MAX) déterminant le courant de crête d'actionneur (Ips) à partir du courant d'actionneur entrant (ip).

24. Système pour exécuter le procédé, selon l'une des revendications 19 à 23, **caractérisé en ce que** l'appareil de commande (ST) comporte un comparateur de charge (K4) qui compare la charge (Qp) transférée à l'actionneur (Pm) avec les valeurs de charge prédéterminées
• la valeur de charge inférieure (Qpmin) et
• la valeur de charge supérieure (Qpmax) et envoie le résultat de la comparaison à l'unité logique (LU), un intégrateur (INT) déterminant la charge d'actionneur (Qp) à partir de l'intégration du courant d'actionneur entrant (ip) sur le temps (t).
